Europäisches Patentamt

European Patent Office

Office européen des brevets

(19)

(11) Publication number: **0 338 084**

A1

# EUROPEAN PATENT APPLICATION

published in accordance with Art. 158(3) EPC

(12)

(21) Application number: 88908375.4

(22) Date of filing: 28.09.88

Data of the international application taken as a basis:

(86) International application number:
PCT/JP88/00987

(87) International publication number:
WO89/03127 (06.04.89 89/08)

(51) Int. Cl.³: **H 01 L 39/24**
H 01 L 39/06, C 01 G 3/00

(30) Priority: 30.09.87 JP 248773/87
01.12.87 JP 305370/87
25.12.87 JP 332982/87

(43) Date of publication of application:
25.10.89 Bulletin 89/43

(84) Designated Contracting States:
DE FR GB

(71) Applicant: MITSUBISHI KINZOKU KABUSHIKI KAISHA
5-2, Otemachi 1-chome
Chiyoda-ku Tokyo 100(JP)

(72) Inventor: MURAKAMI, Yoshio Mitsubishi K.K.K. Chuo
Kenkyujo
297, Kitabukurocho 1-chome
Omiya-shi Saitama 330(JP)

(72) Inventor: SUGIHARA, Tadashi Mitsubishi K.K.K. Chuo
Kenkyujo
297, Kitabukurocho 1-chome
Omiya-shi Saitama 330(JP)

(72) Inventor: TAKESHITA, Takuo Mitsubishi K.K.K. Chuo
Kenkyujo
297, Kitabukurocho 1-chome
Omiya-shi Saitama 330(JP)

(74) Representative: Glawe, Delfs, Moll & Partner
Patentanwälte
Postfach 162 Liebherrstrasse 20
D-8000 München 26(DE)

(54) STRUCTURE OF SUPERCONDUCTOR WIRING AND PROCESS FOR ITS FORMATION.

(57) A wiring of this invention is formed of oxides of at least one rare earth element, at least one alkaline earth metal element and copper in an insulating substance not containing, or containing only a deficient amount of, at least one of the four elements constituting the above-described oxides. Therefore, the wiring is not influenced by those substances which are contained in an environment for use or in the atmosphere, such as carbon dioxide, thus showing superconductivity over a long period of time.

FIG.11

SPECIFICATION

STRUCTURE OF SUPERCONDUCTIVE WIRING AND

PROCESS OF FABRICATION THEREOF

TECHNICAL FIELD

This invention relates to a superconductive wiring and, more particularly, to a wiring structure of a superconductive ceramic material and a process of fabrication thereof.

BACKGROUND ART

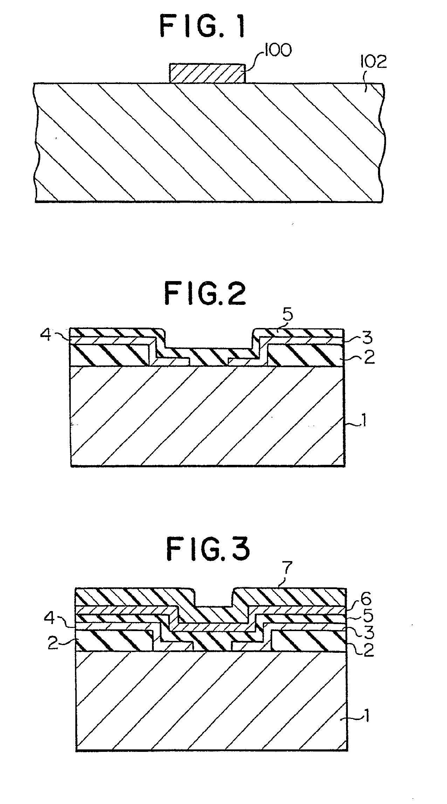

A typical example of the wiring structure is reported by Yamanaka et al. in the paper entitled as "Techniques for Formation of Superconductive Wiring on Alumina Substrate", Electronic Parts and Materials, August 1987, Vol. 26, No. 8, pages 89 to 92. According to the paper, as shown in FIg. 1, the wiring strips are formed by sintering paste lines 100 printed on an usual alumina substrate and an FGA substrate ( which is spelled out as "Fine Grained Alumina" substrate ), and the paste is prepared by mixing a powder of yttrium-barium-copper oxide into an organic vehicle. The plural wiring strips 100 are directly printed on the usual alumina substrate 102 and the FGA substrate, and no protective film is applied to the wiring strip 100. The usual alumina substrate 102 is lower in purity than the FGA substrate and, for this reason, contains a substantial amount of impurity atoms.

A problem is encountered in the prior-art wiring strips 100

1

in stability. Namely, the wiring strips 100 tend to lose the superconductivity after a relatively short period of time, and, accordingly, current paths are blocked in the wiring strips 100.

Another prior-art superconductive strip is formed by using a sputtering technique. Namely, a target of an yttrium-barium-copper oxide is sputtered in vacuum to deposit the amorphous superconductive material film, and, then, the superconductive material film is heated in an argon gas ambient at about 900 degrees in centigrade for the crystallization.

However, the above mentioned superconductive strip is crystallized through the high temperature annealing process, and, for this reason, the oxygen is volatilized from the superconductive material film, thereby causing the superconductive material to deviate from a preselected composition. Since the critical temperature Tc of a superconductive ceramic material is fairly dominated by the composition thereof, the superconductive ceramic material is hardly reproduced in the preselected composition by using the sputtering technique, because the amount of oxygen volatilized is not controllable over the annealing process.

It is therefore an important object of the present invention to provide a structure of superconductive wiring which is capable of staying in the superconductive state in a prolonged time period.

2

It is also an important object of the present invention to provide a process of fabricating the structure of the superconductive wiring which is improved in controllability of the composition.

## DISCLOSURE OF INVENTION

To accomplish these objects, the present invention proposes to form a superconductive ceramic wiring in an insulating material which lacks or is poverty in at least one element selected from the indispensable elements of the superconductive ceramic material.

In accordance with one aspect of the present invention, there is provided a structure of a superconductive wiring comprising: an insulator of a compound containing three elements selected from four elements consisting of at least one element selected from the group consisting of scandium, yttrium and lanthanide series, at least one alkaline earth metal, copper and oxygen; and a wiring strip of a superconductive ceramic material electrically isolated from the insulator and formed of an oxygen compound containing at least one element selected from the group consisting of scandium, yttrium and lanthanide series, at least one alkaline earth metal, and copper.

In accordance with another aspect of the present invention, there is provided a process of fabricating a superconductive wiring structure, comprising the steps of: forming an insulating layer formed of an insulating compound containing three elements selected from four elements consisting of at least one element selected from the group consisting of scandium, yttrium and lanthanide series, at least one alkaline earth metal, copper and oxygen; defining a wiring forming region in the insulating layer; and doping an element excluded from the four element used for formation of the insulating compound into the wiring forming region by using an ion implantation technique.

More than two elements may be selected from the group consisting of scandium, yttrium and lanthanide series, and two alkaline earth metals may be contained.

BRIEF DESCRIPTION OF DRAWINGS

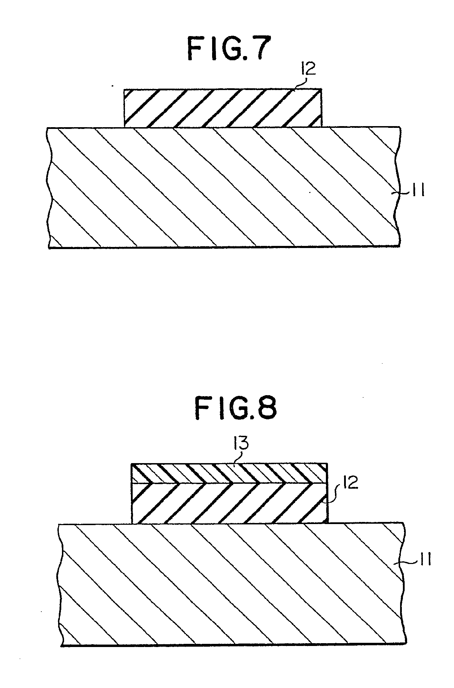

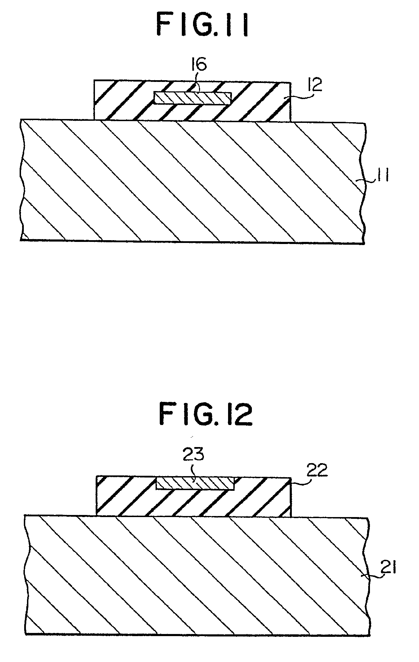

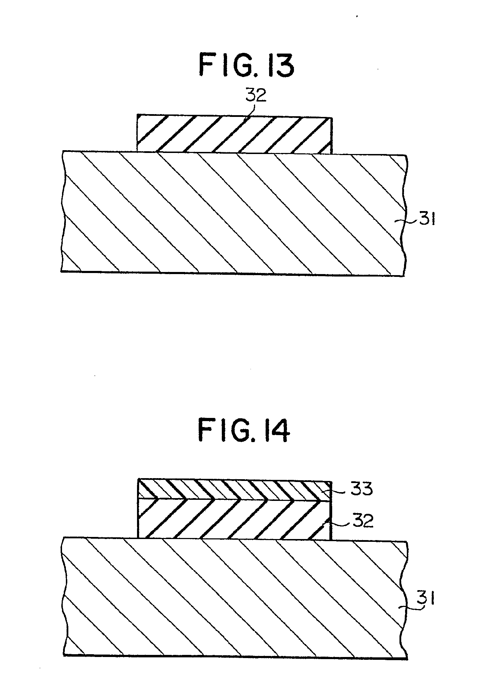

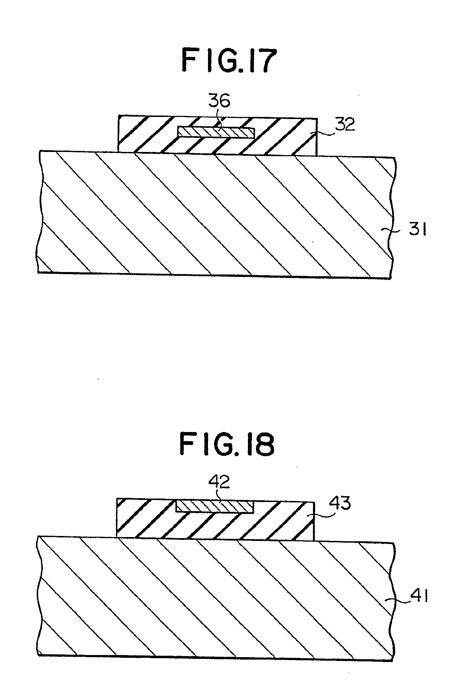

Fig. 1 is a cross sectional view showing the wiring structure proposed by Yamanaka et al., Figs. 2 to 6 are cross sectional views showing a process sequence for fabrication of a first example of a superconductive wiring structure according to the present invention, Figs. 7 to 11 are cross sectional views showing a process sequence for fabrication of a second example of the superconductive wiring structure according to the present invention, Fig. 12 is a cross sectional view showing a third example of the superconductive wiring structure according to the present invention, Figs. 14 to 17 are cross sectional views showing a process sequence for fabrication of a fourth example of the superconductive wiring structure according to the present

4

invention, and Fig. 18 is a cross sectional view showing a fifth example of the superconductive wiring structure according to the present invention.

### BEST MODE FOR CARRYING OUT THE INVENTION

#### First example

Referring first to Figs. 2 to 6, description is made for an example applying the present invention to a wiring film incorporated in a thin film integrated circuit.

Reference numeral 1 designates a semiconductor substrate of, for example, single crystalline silicon, and an insulating film 2 of, for example, silicon dioxide is grown on the major surface of the semiconductor substrate 1. The insulating film 2 is partially removed to expose the surface of the semiconductor substrate 1, and a source electrode 3 and a drain electrode 4 are confronted with each other on the exposed surface by a distance of about 0.5 micron. The source electrode 3, the drain electrode 4 and the exposed surface of the semiconductor substrate 1 are covered with an insulating film 5, and a gate electrode of a superconductive ceramic material is formed on the insulating film 5 over the surface providing the distance of about 0.5 micron through a process sequence which will be described hereinlater. The resultant structure of this stage is illustrated in Fig. 2.

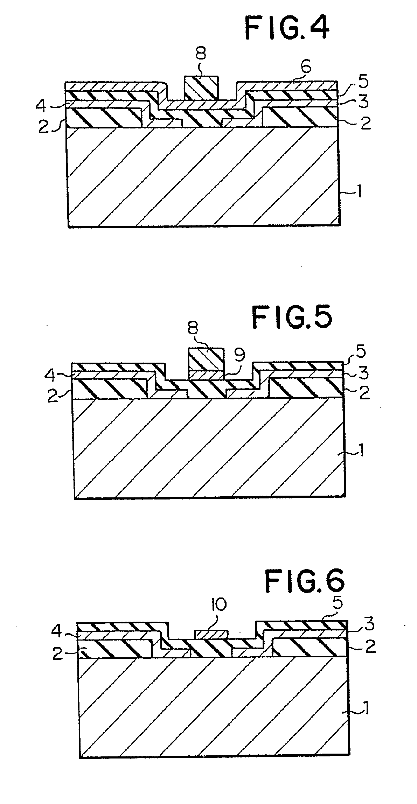

Subsequently, there is prepared a target formed of a compound containing one or a plurality of elements selected from the group consisting of scandium, yttrium and lanthanide series, one or a plurality of alkaline earth metals and copper, and, then, the target is sputtered in vacuum to deposit a wiring film 6 in an amorphous state on the insulating film 5. The target is intentionally formed without oxygen, and, for this reason, the wiring film 6 does not contain any oxygen, or a negligible amount of oxygen may be contained therein. Subsequently, the wiring structure is placed in a high temperature ambient for annealing, thereby being crystallized. As described hereinbefore, the wiring film 6 does not contain any oxygen in this stage, so that no deviation takes place in the composition over the high temperature annealing process. As shown in Fig. 3, the wiring film 6 is coated with a photo resist film 7, and the photo resist film 7 is patterned through a sequence of lithography process to form a mask layer 8. The resultant structure of this stage is illustrated in Fig. 4.

The mask layer 8 is thus formed, then the wiring film 6 is partially removed by using a reactive ion etching technique as shown in Fig. 5, thereby providing a wiring strip 9. The wiring strip has a width of about 0.5 micron. When the wiring strip 9 is shaped, the mask layer 8 is stripped off, and, then, oxygen atoms are ion-implanted into the wiring strip 9. The amount of the oxygen atoms are selected in such a manner as to be sufficient to form a predetermined composition of the superconductive ceramic material, so that the superconductive ceramic material of this instance is finally represented by the molecular formula of $(Yb_{0.32}Ba_{0.68})Cu_1O_{3-\delta}$. When the ion-implantation is completed, an annealing is carried out at about 500 degrees in centigrade, and the wiring structure 10 of the superconductive ceramic is fabricated as shown in Fig. 6. The annealing after the ion-implantation is lower in temperature than the annealing after the sputtering, and, for this reason, the deviation in the composition due to volatilization of the oxygen is negligible.

In addition, the insulating film 5 may be relatively thick for protecting the source electrode 3 and the drain electrode 4 from the ion implantation.

The wiring strip 10 of the superconductive ceramic material thus formed through the process sequence serves as the gate electrode of a field effect transistor. When the voltage level applied to the gate electrode is controlled, the semiconductor boundary region is increased in carrier density, then a wave motion further extends from the gate electrode, thereby allowing the wave from the source electrode 3 to merge into the wave from the drain electrode 4 for creating a superconducting state. Then, if the semiconductor boundary region is shifted between the superconducting state and the usual conducting state by controlling the voltage level at the gate electrode, the

7

transistor behavior will be achieved.

In this instance, the semiconductor substrate is formed of single crystalline silicon, however, a compound semiconductor material such as, for example, indium-arsenide is available. Moreover, the lithography techniques are used for the patterning, however, the patterning is not limited to the lithography process. The deposition of the wiring film is not limited to the sputtering technique, so that the wiring film may be deposited by using, for example, an evaporation system with three evaporation sources or an ion plating system. Further, the wiring strip may be formed of an oxygen compound containing a plurality of elements selected from the group consisting of scandium, yttrium and lanthanide series, a plurality of alkaline earth metals and copper, the oxygen compound is by way of example represented by the molecular formula of $(Gd_{0.5}Ho_{0.5})_{1.0}(Ba_{0.9}Sr_{0.1})_{2.0}Cu_{3.0}O_{6.9}$ or the molecular formula of $(Er_{0.6}Sm_{0.4})_{1.0}(Ba_{0.95}Ca_{0.05})_{2.0}Cu_{3.0}O_{6.9}$.

Second example

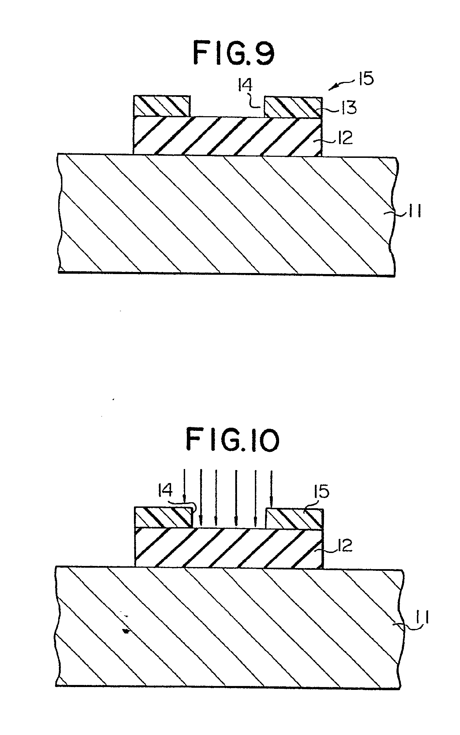

Turning to Figs. 7 to 11, description is made for a second example of the wiring strip incorporated in a thick film integrated circuit fabricated on an yttria stabilized zirconia substrate 11. First, as shown in Fig. 7, an insulating film 12 is formed on the yttria stabilized zirconia substrate 11. The insulating film 12 is formed of an oxygen compound containing

8

yttrium and copper and, by way of example, patterned by using a screen printing technique. Next, as shown in Fig. 8, a photo resist film 13 is spun onto the insulating film 12, and the thickness of the photo resist film 13 is selected in such a manner as to be sufficient to prevent the insulating film 12 except for a wiring forming region defined therein from ions implanted during an ion implantation stage which will be described hereinafter. .

The photo resist film 13 is partially removed by using lithography techniques to form an opening exposing the wiring forming region. Thus, a mask layer 15 is formed as shown in Fig. 9. Next, barium atoms are ion-implanted into the wiring forming region. In this example, the implantation energy is selected to be of the order of 200 KeV, so that the barium atoms penetrate into the insulating film 12 and the penetration range is about 350 angstroms ( see Fig. 10 ). However, the insulating film except for the wiring forming region is covered with the mask layer 15, and, for this reason, no barium atom is doped therein. If the penetration range is selected to be about 1000 angstroms for the barium atoms, the accelerator of the ion-implantation system should be set to about 1 MeV.

After the ion implantation, the mask layer 15 is stripped off from the insulating film 12, and a low temperature annealing is carried out at about 500 degrees in centigrade for activation

9

of the implanted atoms. Upon completion of the annealing, the oxygen poverty due to the ion implantation is dissolved, and, accordingly, a wiring layer 16 of an yttrium-barium-copper oxide is formed in the insulating film 12 as shown in Fig. 11. The profile of the implanted barium atoms is approximated by a symmetric Gaussian distribution function. Then, when the barium atoms are implanted at about 200 KeV, the barium atom profile traces a Gaussian curve with a peak value at about 350 angstroms, and, for this reason, the wiring layer 16 is formed inside the insulating film 12 as shown in Fig. 11. As a result, the wiring layer 16 is less liable to have an influence of vapor and carbon dioxide in the atmosphere and, accordingly, allowed to stay in the superconductive state for a prolonged time period.

In this example, the insulating film 12 is formed on the substrate 11, the insulating film may serve as a substrate. Moreover, the insulating film may be formed of an oxygen compound containing barium and copper, and, in this example, yttrium ions are ion-implanted therein. If the insulating film is formed of an oxygen compound containing yttrium and barium, copper atoms should be ion-implanted therein. While implanting ions, a focused ion beam may be used for a direct patterning. If the direct patterning and a deposition of an yttrium-copper oxide are repeated, a three-dimensional integrated circuit will be fabricated.

## Third example

Fig. 12 is a cross sectional view showing the wiring structure of a third example according to the present invention. In this example, on an yttria stabilized zirconia substrate 21 is screed printed an insulating film 21 of an oxygen compound containing yttrium and copper which is covered with a mask layer ( not shown ) except for a wiring forming region. Then, barium ions are ion-implanted into the wiring forming region. In this ion implantation stage, the implantation energy is stepwise changed to form a wiring region 23 penetrating in a direction of the depth of the insulating film 22. In this example, the accelerator of the ion-implantation system increases an implantation energy of three steps, i. e., about 50 KeV, about 100 KeV and about 300 KeV. As a result, three Gaussian curves are partially overlapped with one another, so that the wiring layer 23 is exposed to the surface of the insulating film 23.

## Fourth example

Turning to Figs. 13 to 17, description is hereinunder made for a fourth example embodying the present invention. The superconductive wiring structure of the fourth example is fabricated on an yttria stabilized zirconia substrate 31 through a process sequence described hereinunder. First, as shown in Fig. 13, an insulating film 32 is patterned on the yttria stabilized zirconia substrate 31 by using, for example, a screen

11

printing technique. The insulating film 32 is formed of an oxygen compound containing yttrium, barium and copper, however, the oxygen composition ratio is selected in such a manner that the oxygen compound does not stay in the superconductive state at a serving temperature.

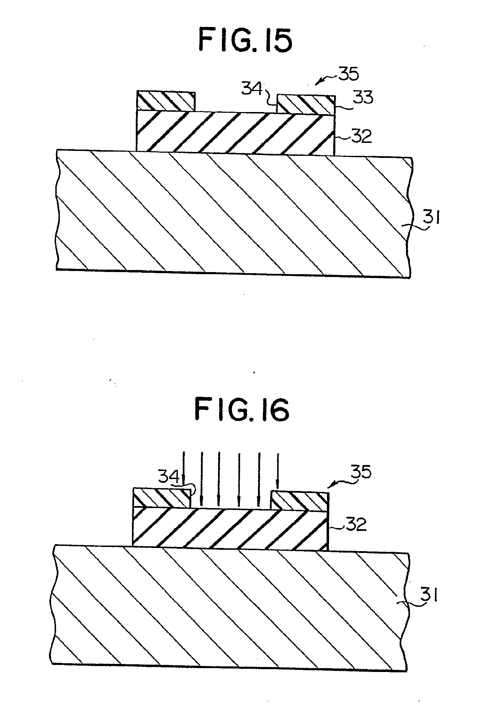

Next, as shown in Fig. 14, a photo resist film 33 is spun onto the insulating film 32, and, then, the photo resist film 33 is patterned to form an opening 34 exposing a wiring forming region as shown in Fig. 15 through usual lithography techniques. The thickness of the photo resist film 33 is selected in such a manner that oxygen atoms hardly reach the insulating film 32 except for the wiring forming region during an ion implantation stage described hereinunder in detail. When a mask layer 35 providing the opening 34 is formed from the photo resist film 33, the oxygen atoms are ion-implanted into the wiring forming region as shown in Fig. 16, thereby causing the wiring forming region to have a composition capable of staying in the superconductive state at the serving temperature. In this example, the implantation energy is selected to be about 50 KeV, so that the oxygen profile has the maximum concentration around 600 angstroms measured from the surface of the insulating film 32. The implantation energy may be changed depending upon the depth of the maximum concentration and is by way of example set to about 200 KeV for the maximum concentration around 3000 angstroms measured from the surface of the insulating film 32. As to the critical temperature of oxygen compounds each containing yttrium, barium and copper, the oxygen compound represented by the molecular formula of $YBa_{2.0}Cu_{3.0}O_{6.9}$ stays in the superconductive state at about 83 degrees in Kelvin scale, however, the oxygen compound represented by the molecular formula of $YBa_{2.0}Cu_{3.0}O_{6.1}$ can not stay in the superconductive state at about 83 degrees in Kelvin scale, and the oxygen compound represented by the molecular formula of $YBa_{2.0}Cu_{3.0}O_{6.6}$ can stay in the superconductive state at about 40 degrees in Kelvin scale. Then, if the serving temperature is selected to be at about 40 degrees in Kelvin scale, the second oxide and the third oxide may be used for forming the insulating film and the wiring layer, respectively, however, if the serving temperature is selected to be at about 83 degrees in Kelvin scale, the first oxide and the second oxide are available.

The mask layer 35 is stripped off, and, then, a low temperature annealing is carried out. As a result, a wiring layer 36 of a superconductive ceramic material is formed inside the insulating film 32 as shown in Fig. 17.

Fifth example

Turning to Fig. 18, there is shown a fifth example of the superconductive wiring structure according to the present invention. The superconductive wiring structure shown in Fig. 18 is fabricated on an yttria stabilized zirconia substrate 41, and a wiring layer 42 of a superconductive ceramic material is exposed to the surface of an insulating film 43. For formation of such a structure, on the yttria stabilized zirconia substrate 41 is screen-printed the insulating film 43 which is covered with a mask layer ( not shown ) except for a wiring forming region. The insulating film 43 is formed of an oxygen compound containing yttrium, barium and copper, however, the oxygen composition ratio is selected in such a manner that the insulating film does not stay in the superconductive state at a serving temperature. Then, oxygen atoms are ion-implanted into the wiring forming region. While the ion implantation, the implantation energy is stepwise varied to allow the wiring layer 42 to extend in a direction of the depth of the insulating film 43. In this example, the accelerator of the ion-implantation system increases the implantation energy of three steps, i. e., about 5 KeV, about 10 KeV and about 30 KeV. As a result, three Gaussian curves are partially overlapped with one another, thereby forming the wiring layer 42 exposed to the surface of the insulating film 43. The wiring layer 42 is substantially uniform in oxygen concentration from the surface of the insulating film 43 to the depth of about 1000 angstroms.

## INDUSTRIAL APPLICABILITY

The superconductive wiring structure and the process of fabrication thereof are applicable to a wiring layer incorporated in a thin film integrated circuit and a wiring pattern of a thick film integrated circuit.

## CLAIMS

1. A structure of a superconductive wiring comprising

an insulator of a compound containing three elements selected from four elements consisting of at least one element selected from the group consisting of scandium, yttrium and lanthanide series, at least one alkaline earth metal, copper and oxygen; and

a wiring strip of a superconductive ceramic material electrically isolated from the insulator and formed of an oxygen compound containing at least one element selected from the group consisting of scandium, yttrium and lanthanide series, at least one alkaline earth metal, and copper.

2. A structure of a superconductive wiring as set forth in claim 1, in which the insulator is formed of a compound containing at least one element selected from the group consisting of scandium, yttrium and lanthanide series, at least one alkaline earth metal and copper.

3. A structure of a superconductive wiring as set forth in claim 1, in which the insulator is formed of an oxygen compound containing two elements selected from the group consisting of at least one element selected from the group consisting of scandium, yttrium and lanthanide series, at least one alkaline earth metal and copper.

4 A structure of a superconductive wiring as set forth in claim 3, in which the insulator is formed of an oxygen compound containing yttrium and copper and in which the superconductive ceramic material is formed of an oxygen compound containing yttrium, barium and copper.

5. A structure of a superconductive wiring as set forth in claim 3, in which the wiring strip of the superconductive ceramic material is formed inside the insulator.

6. A structure of a superconductive wiring as set forth in claim 3, in which the wiring strip of the superconductive ceramic material is exposed to a surface of the insulator.

7. a structure of a superconductive wiring as set forth in claim 1, in which the insulator is different in the oxygen composition ratio from the superconductive ceramic material.

8. A structure of a superconductive wiring comprising

an insulator of a compound containing three elements selected from four elements consisting of a plurality of elements selected from the group consisting of scandium, yttrium and lanthanide series, a plurality of alkaline earth metals, copper and oxygen; and

a wiring strip of a superconductive ceramic material electrically isolated from the insulator and formed of an oxygen compound containing a plurality of elements selected from the group consisting of scandium, yttrium and lanthanide series, a plurality of alkaline earth metals, and copper.

9. A process of fabricating a superconductive wiring structure,

17

comprising the steps of:

forming an insulating layer formed of an insulating compound composed of three elements selected from four elements consisting of at least one element selected from the group consisting of scandium, yttrium and lanthanide series, at least one alkaline earth metal, copper and oxygen;

defining a wiring forming region in the insulating layer; and

doping an element excluded from the four element used for formation of the insulating compound into the wiring forming region by using an ion implantation technique.

10. A process of fabricating a superconductive wiring structure as set forth in claim 9, in which the wiring forming region is defined in the insulating layer by using a patterning technique.

11. A process of fabricating a superconductive wiring structure as set forth in claim 10, in which the wiring forming region is annealed at a low temperature after the ion implantation technique.

12. A process of fabricating a superconductive wiring structure as set forth in claim 9, in which the wiring forming region is defined by a mask layer formed on the insulating layer in such a manner as to be exposed.

13. A process of fabricating a superconductive wiring structure as set forth in claim 12, in which the insulating layer is formed of an oxygen compound containing yttrium and copper and in which

18

barium atoms are ion-implanted into the oxygen compound.

14. A process of fabricating a superconductive wiring structure as set forth in claim 13, in which the ion implantation technique is carried out with an implantation energy uniformly maintained.

15. A process of fabricating a superconductive wiring structure as set forth in claim 14, in which the implantation energy is approximately equal to about 200 KeV.

16. A process of fabricating a superconductive wiring structure as set forth in claim 13, in which the ion implantation technique is carried out with a variable implantation energy.

17. A process of fabricating a superconductive wiring structure as set forth in claim 16, in which the variable implantation energy is changed from about 50 KeV to about 300 KeV.

18. A process of fabricating a superconductive wiring structure, comprising the steps of:

forming an insulating layer staying in an electrically insulating state at a serving temperature and formed of an oxygen compound containing at least one element selected from the group consisting of scandium, yttrium and lanthanide series, at least one alkaline earth metal and copper;

defining a wiring forming region in the insulating layer;

doping oxygen atoms into the wiring forming region by using an ion implantation technique to form a wiring layer of a superconductive ceramic material.

19

19.  A process of fabricating a superconductive wiring structure as set forth in claim 18, in which the wiring forming region is annealed at a low temperature after the ion implantation technique.

20.  A process of fabricating a superconductive wiring structure as set forth in claim 19, in which the mask layer formed on the insulating layer allows the wiring forming region to be exposed.

21.  A process of fabricating a superconductive wiring structure as set forth in claim 20, in which the ion implantation technique is carried out with an implantation energy uniformly maintained.

22.  A process of fabricating a superconductive wiring structure as set forth in claim 21, in which the implantation energy is approximately equal to about 50 KeV.

23.  A process of fabricating a superconductive wiring structure as set forth in claim 20, in which the ion implantation technique is carried out with a variable implantation energy.

24.  A process of fabricating a superconductive wiring structure as set forth in claim 23, in which the variable implantation energy is changed from about 5 KeV to about 30 KeV.

# FIG.1

# FIG.2

# FIG.3

**FIG.4**

**FIG.5**

**FIG.6**

## FIG.7

12

11

## FIG.8

13

12

11

## FIG.9

## FIG.10

## FIG.11

## FIG.12

# FIG. 13

32

31

# FIG. 14

33

32

31

## FIG. 15

## FIG. 16

0338084

## FIG.17

## FIG.18

# INTERNATIONAL SEARCH REPORT

International Application No  PCT/JP88/00987

## I. CLASSIFICATION OF SUBJECT MATTER (if several classification symbols apply, indicate all) [6]

According to International Patent Classification (IPC) or to both National Classification and IPC

$Int.Cl^4$  H01L39/24, H01L39/06, C01G3/00

## II. FIELDS SEARCHED

| Minimum Documentation Searched [7] | |
|---|---|
| Classification System | Classification Symbols |
| IPC | H01L39/00-39/24, C01G3/00 |

| Documentation Searched other than Minimum Documentation to the Extent that such Documents are Included in the Fields Searched [8] |
|---|
| |

## III. DOCUMENTS CONSIDERED TO BE RELEVANT [9]

| Category * | Citation of Document, [11] with indication, where appropriate, of the relevant passages [12] | Relevant to Claim No. [13] |
|---|---|---|
| A | Zeitschrift für Physik B Condensed Matter, Vol. 64, (1986), J. G. Bednorz and K. A. Müller [Possible High Tc Superconductivity in the Ba-La-Cu-O System] P.189-193 | 1-24 |
| A | Physical Review Letters, Vol. 58, No. 9, (1987), M. K. Wu. et al [Superconductivity at 93K in a New Mixed-Phase Y-Ba-Cu-O Compound System at Ambient Pressure] P.908-910 | 1-24 |
| E | JP, A, 63-265473 (Kogyo Gijutsuin-cho) 1 November 1988 (01. 11. 88) (Family: none) | 1-24 |
| Y | JP, B2, 58-45194 (Nippon Telegraph & Telephone Public Corporation) 7 October 1983 (07. 10. 83) (Family: none) | 1-24 |

* Special categories of cited documents: [10]
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step
"Y" document of particular relevance; the claimed invention cannot be considered to involve an inventive step when the document is combined with one or more other such documents, such combination being obvious to a person skilled in the art
"&" document member of the same patent family

## IV. CERTIFICATION

| Date of the Actual Completion of the International Search | Date of Mailing of this International Search Report |
|---|---|
| December 7, 1988 (07. 12. 88) | December 19, 1988 (19. 12. 88) |
| International Searching Authority | Signature of Authorized Officer |
| Japanese Patent Office | |

Form PCT/ISA/210 (second sheet) (January 1985)